# EUROPEAN PATENT SPECIFICATION

(11) **EP 0 522 676 B1**
(45) Date of publication and mention of the grant of the patent: **22.11.1995**
(21) Application number: 92300540.9
(22) Date of filing: 22.01.1992
(51) Int. Cl.: H03H 9/05

(54) **Longitudinal quartz crystal resonator**
Längsquarz-Kristallresonator
Résonateur longitudinal à cristal de quartz

(30) Priority: 10.07.1991 JP 170150/91
(43) Date of publication of application: 13.01.1993
(73) Proprietor: SEIKO ELECTRONIC COMPONENTS LTD., Sendai-shi, Miyagi-ken 982 (JP)
(72) Inventor: Kawashima, Hirofumi, c/o SEIKO ELEC.COMPONENTS LTD, Sendai-shi, Miyagi (JP)
(74) Representative: Sturt, Clifford Mark

(56) References cited:
- PATENT ABSTRACTS OF JAPAN vol. 014, no. 259 (E-0937)5 June 1990 & JP-A-20 79 511 (SEIKO) 20 March 1990
- PATENT ABSTRACTS OF JAPAN vol. 015, no. 121 (E-1049) 25 March 1991 & JP-A-30 10 509 (SEIKO) 18 January 1991
- PATENT ABSTRACTS OF JAPAN vol. 014, no. 374 (E-0964) 13 August 1990 & JP-A-21 35 907 (SEIKO) 24 May 1990

## Description

The present invention relates to a longitudinal quartz crystal resonator, e.g. a resonator comprised of a vibrational portion and a support portion which are formed integrally by an etching process. More specifically, the present invention relates to a longitudinal quartz crystal resonator having a shape suitable for a clock signal source of a portable instrument such as an IC card, a pager and a movable communication device, the resonator being of reduced size and power consumption.

In a known longitudinal quartz crystal resonator comprised of a vibrational portion and a support portion which are integrally formed by an etching process, the vibrational portion is composed of a single vibrating arm, thereby failing to reduce the series resistance R₁. The known longitudinal quartz crystal resonator having a single vibrating arm has therefore a relatively small overall mass. Therefore, the known resonator suffers from asymmetricity of the shape caused by the etching process due to the structural anisotropy of quartz crystal. The asymmetricity of shape may affect oscillating performance. In view of this, the known resonator has a relatively great energy loss of vibration through the support portion, thereby causing serious problems such as an undesirably high value of R₁. Further, there remains simultaneously another problem that the oscillation starting response is relatively slow due to the great amount of equivalent inductance L₁. There has therefore long been desired a longitudinal quartz crystal resonator having small values of R₁ and L₁.

According to the present invention, there is provided a longitudinal quartz crystal resonator comprising vibrating means connected via bridge means to frame means characterised in that the resonator comprises at least one assembly of vibrating arms arranged parallel to each other; connecting sections which connect the vibrating arms of the or each said assembly to each other at their opposite ends; and bridge sections which interconnect the central part of each said assembly to a portion of the frame means.

At least one said assembly may comprise at least three vibrating arms arranged parallel to each other.

Preferably, the frame means comprises a mount section connected integrally to respective ends of a pair of spaced apart frame sections whose opposite ends are connected directly or indirectly to respective bridge sections.

At least one said assembly may extend outwardly of the frame means.

There may be at least three said assemblies. In this case, the centrally located one of said assemblies may be provided with more vibrating arms than the others thereof and/or may extend outwardly of the said other assemblies. Only the centrally located assembly, moreover, may be provided with excitation electrodes, whereby the outer assemblies assist in confining the vibrational energy within the centrally located assembly.

In one embodiment, the or each said assembly is completely surrounded by portions of the frame means.

A resonator according to the present invention has a plurality of vibrating arms held by a support portion. The total mass of the plurality of vibrating arms may be arranged to be greater than the mass of a single vibrating arm so that a resonator according to the present invention has a greater potential energy. Accordingly, the resistance force applied from the support portion to each vibrating arm can be reduced, when estimated per each vibrating arm. The electromagnetic energy is increased at the same time. Accordingly, there can be obtained a longitudinal quartz crystal resonator having reduced values of the series resistance R₁ and the equivalent inductance L₁.

The invention is illustrated, merely by way of example, in the accompanying drawings, in which:-
Figure 1 is a plan view showing a first embodiment of a longitudinal quartz crystal resonator according to the present invention;
Figure 2 is a plan view showing a second embodiment of a longitudinal quartz crystal resonator according to the present invention;
Figure 3 is a plan view showing a third embodiment of a longitudinal quartz crystal resonator according to the present invention;
Figure 4 is a plan view showing a fourth embodiment of a longitudinal quartz crystal resonator according to the present invention; and
Figure 5 is a plan view showing a fifth embodiment of a longitudinal quartz crystal resonator according to the present invention.

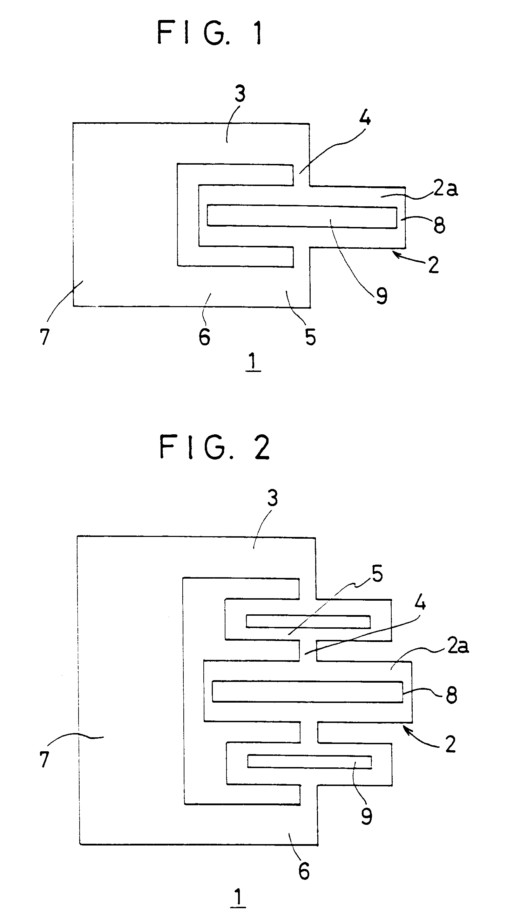

Figure 1 shows a plan view of a first embodiment of a longitudinal quartz crystal resonator according to the present invention. The resonator 1 is comprised of a single vibrational portion 2 and a support portion 3 coupled to the vibrational portion 2 through bridge sections 4. Further, the vibrational portion 2 is comprised of an assembly of two vibrating arms 2a which are arranged parallel to each other and which are connected to each other at their opposite ends through connecting sections 8 which are substantially free of strain to thereby enclose an opening 9.

The support portion 3 is comprised of a pair of frame sections 6 which are integral with and whose ends extend from mount section 7. Each frame section 6 is connected at its opposite end to the corresponding bridge section 4 which extends from a central or intermediate part of the respective vibrating arm 2a to form a flextional section 5 which undergoes a flexional vibration. As will be seen, the assembly 2 extends outwardly of the frame 3, 6, 7. Further, excitation electrodes (not shown) are arranged such as to vibrate the pair of vibrating arms 2a in the same direction.

Consequently, the resonator of Figure 1 has an equivalent inductance reduced by half, an equivalent capacitance increased by double, and a series resistance R₁ reduced by half, as compared to a known resonator having a single vibrating arm, these values being measured in the resonant oscillating state. For example, a known resonator of the single vibrating arm type has a series resistance value of R₁=380Ω at a frequency of f≒450KHz, whereas the inventive resonator of Figure 1 having the double vibrating arms has a series resistance value of R₁=195Ω which is significantly reduced by half.

Figure 2 shows a plan view of a second embodiment of a longitudinal quartz crystal resonator according to the present invention. The resonator 1 of this embodiment is comprised of three vibrational portions 2 and a support portion 3. The centrally located vibrational portion 2 extends outwardly of the outer vibrational portions 2. Each vibrational portion 2 is comprised of an assembly of two vibrating arms 2a and connecting sections 8 arranged in manner similar to the Figure 1 resonator. The supporting portion 3 is constructed to confine the vibrating energy more efficiently within the vibrational portions 2 which are provided with the openings 9, such that the supporting portion 3 is comprised of a pair of bridge sections 4, corresponding flexional sections connected to the respective bridge sections 4, corresponding frame sections 6 coupled to the respective flexional sections 5, and a mount section 7 connected to the pair of frame sections 6. By means of such a construction, the series resistance R₁ is further reduced and simultaneously the vibrating energy is more efficiently confined within the vibrational portions, thereby providing an improved longitudinal quartz crystal resonator substantially free of vibrating energy loss.

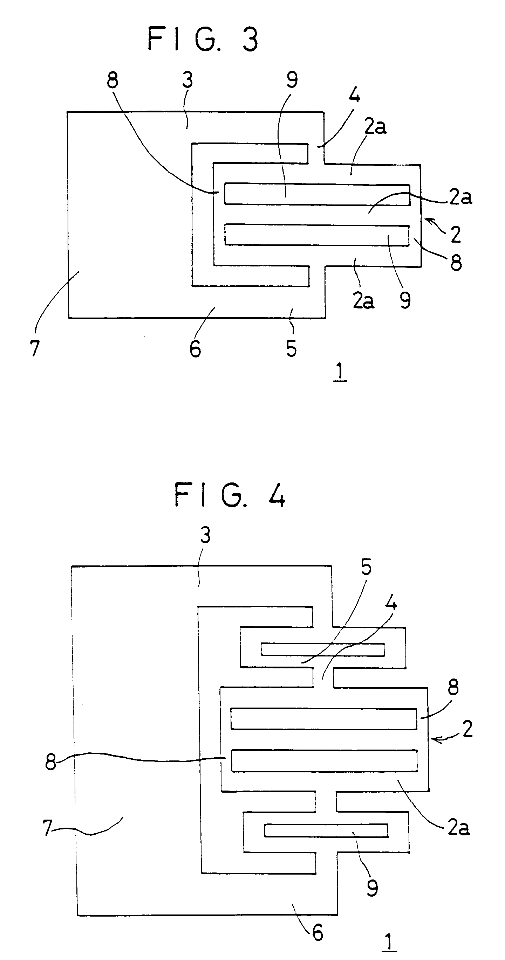

Figure 3 shows a plan view of a third embodiment of a longitudinal quartz crystal resonator according to the present invention. The resonator 1 is comprised of a single vibrational portion 2 and a support portion 3 coupled to the vibrational portion 2 through a pair of bridge sections 4. The vibrational portion 2 is comprised of an assembly of three vibrating arms 2a arranged parallel to each other, the arms 2a being connected together at their ends which are substantially free of strain through connecting sections 8 to form openings 9. Further, the bridge sections 4 extend from intermediate parts of the outermost pair of vibrating arms 2a, a pair of frame sections 6 including a pair of flexional sections 5 being connected to the corresponding bridge sections 4 to undergo a flexional vibration according to Poisson's ratio. Further, excitation electrodes (not shown) are arranged to vibrate or drive the three vibrating arms 2a in the same direction. Consequently in the resonant oscillating state of the resonator, the equivalent inductance is reduced by about one-third, the equivalent capacitance is increased by about three times, and the series resistance is reduced by about one-third, as compared to the known resonator of the single vibrating arm type.

Figure 4 shows a plan view of a fourth embodiment of a longitudinal quartz crystal resonator according to the present invention. The resonator 1 is comprised of three vibrational portions 2 and a support portion 3. The central vibrational portion 2 is composed of an assembly of three vibrating arms 2a and connecting sections 8 arranged in a manner similar to the Figure 3 resonator. The support portion 3 is constructed so as to confine the vibrating energy more efficiently within the vibrational portions 2, such that the support portion 3 is composed of a pair of flexional sections 5 connected to respective bridge sections 4, a pair of frame sections 6 connected at their opposite ends to the corresponding flexional sections 5, and a mount section 7 connected to the frame sections 6. By means of such a construction, the series resistance R₁ is further reduced, while the vibrating energy is more efficiently confined within the vibrational portions, thereby producing an improved longitudinal quartz crystal resonator substantially free of vibratingenergy loss.

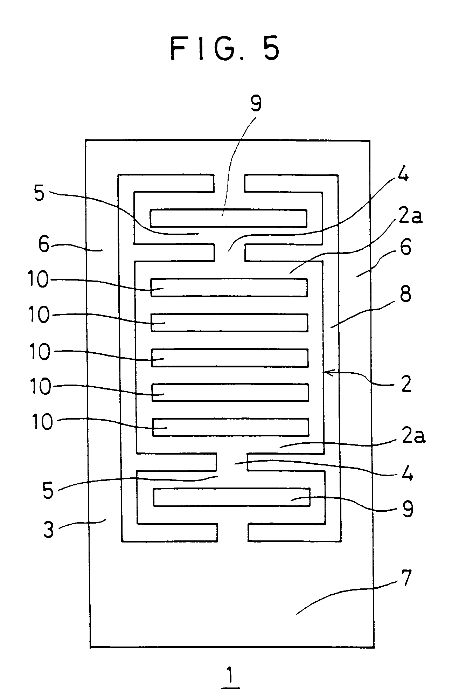

Figure 5 shows a plan view of a fifth embodiment of a longitudinal quartz crystal resonator according to the present invention. The resonator 1 is comprised of three vibrational portions 2, and a support portion 3 connected to the vibrational portion s 2 through bridge sections 4. The vibrational portions 2 are completely surrounded by portions of the frame. Further, the central vibrational portion 2 is comprised of six vibrating arms 2a arranged parallel to each other and coupled together at their opposite end portions which are substantially free of strain through connecting sections 8 to form openings 10. The support portion 3 is constructed to confine the vibrating energy efficiently within the vibrational portions 2. Namely, the support portion 3 is comprised of a pair of flexional sections 5 connected to the respective bridge sections 4, a pair of frame sections 6 each connected at one end thereof to the corresponding flexional section 5, and a mount section 7 connected to the pair of frame sections 6. Further, exciting electrodes (not shown) are formed on etched faces of the six vibrating arms 2a. Thus the centrally located vibrational portion 2 is provided with more vibrating arms 2a than each of the outer vibrational portions 2 each of which is provided with only two vibrating arms 2a. If each of the outer vibrational portions 2 is not provided with an exciting electrode, it assists in confining the vibrational energy within the central vibrational portion 2.

Accordingly, in the resonant oscillating state, the resonator 1 of Figure 5 has an equivalent inductance reduced by about one-sixth, an equivalent capacitance increased by about six times, and a series resistance R₁ reduced by more or less one-sixth though depending on design detail of the support portion 3, as compared to the known resonator of the single vibrating arm type. In general if N number of vibrating arms are integrated in the vibrational portion, the equivalent inductance is reduced by about one-Nth.

By means of such a construction, the equivalent inductance is significantly reduced so that the duration of the start of the oscillation can be shortened to achieve quick start response. Further, the series resistance R₁ is reduced while the vibrating energy is confined within the vibrational portion, thereby providing an improved longitudinal quartz crystal resonator substantially free of vibrating energy loss. Moreover, although a resonator of the present invention has a complicated configuration, the resonator can be integrally formed by a chemical etching process.

A longitudinal quartz crystal resonator as described above has a new shape which is comprised of a vibrational portion and a support portion and which is formed integrally by an etching process, thereby achieving the following effects:
(1) A plurality of vibrating arms are provided so that the equivalent inductance of the resonator can be reduced to thereby shorten the starting time at the start of the oscillation.
(2) The series resistance R₁ of the resonator is also reduced by integrating a plurality of the vibrating arms.
(3) The vibrational portion and the support portion are formed integrally by an etching process, thereby reducing the size and thickness of the resonator.
(4) The shape of the support portion is improved to thereby produce a resonator substantially free of vibrating energy loss. Therefore, the resonator has a small series resistance R₁, while the resonator may be connected to external leads through the mount section of the resonator.
(5) A plurality of the resonators may be produced by a batch etching process, each individual resonator being connected to external leads at the mount section disposed on one side of the resonator, thereby facilitating production at low cost.

## Claims

1. A longitudinal quartz crystal resonator comprising vibrating means (2) connected via bridge means (4) to frame means (3,6,7) characterised in that the resonator comprises at least one assembly (2) of vibrating arms (2a) arranged parallel to each other; connecting sections (8) which connect the vibrating arms (2a) of the or each said assembly (2) to each other at their opposite ends; and bridge sections (4) which interconnect the central part of each said assembly (2) to a portion of the frame means( 3,6,7).

2. A resonator as claimed in claim 1 characterised in that at least one said assembly (2) comprises at least three vibrating arms (2a) arranged parallel to each other.

3. A resonator as claimed in claim 1 or 2 characterised in that the frame means (3,6,7) comprises a mount section (7) connected integrally to respective ends of a pair of spaced apart frame sections (6) whose opposite ends are connected directly or indirectly to respective bridge sections (4).

4. A resonator as claimed in claim 1 or 2 characterised in that at least one said assembly (2) extends outwardly of the frame means (3,6,7).

5. A resonator as claimed in any preceding claim characterised in that there are at least three said assemblies (2).

6. A resonator as claimed in claim 5 characterised in that a centrally located one of said assemblies (2), is provided with more vibrating arms (2a) than the others thereof.

7. A resonator as claimed in claim 5 or 6 characterised in that the centrally located assembly (2) extends outwardly of the said other assemblies (2).

8. A resonator as claimed in any of claims 1, 2, 3, 5, 6 or 7 characterised in that the or each said assembly (2) is completely surrounded by portions of the frame means (3,6,7).

9. A resonator as claimed in any of claims 5-7 characterised in that only the centrally located assembly (2) is provided with excitation electrodes, whereby the outer assemblies assist in confining the vibrational energy within the centrally located assembly.

10. A longitudinal quartz crystal resonator comprising: a pair of vibrating arms (2a) arranged in parallel to each other; connecting sections (8) for connecting the pair of vibrating arms (2a) at their ends; bridge sections (4) extending from intermediate parts of the respective vibrating arms (2a); and a pair of frame sections (6) connected to the respective bridge sections (4) and being supported integrally at their ends.

11. A longitudinal quartz crystal resonator comprising: at least three vibrating arms (2a) arranged in parallel to each other; connecting sections (8) for connecting the vibrating arms (2a) at their ends; a pair of bridge sections (4) extending from intermediate parts of an outermost pair of the vibrating arms; and a pair of frame sections (6) connected to the respective bridge sections (4) and being supported integrally at their ends.

## Patentansprüche

1. Längs-Quarzkristallresonator, umfassend Vibratormittel (2), welche über Brückenmittel (4) mit einem Rahmenmittel (3, 6, 7) verbunden sind,
dadurch gekennzeichnet, daß der Resonator wenigstens eine Anordnung (2) von Schwingungsarmen (2a) umfaßt, welche parallel zueinander angeordnet sind, Verbindungsabschnitte (8), welche die Schwingungsarme (2a) von der Anordnung oder jeder der Anordnungen (2) an ihren entgegengesetzten Enden miteinander verbinden, und Brückenabschnitte (4), welche den zentralen Teil von jeder der Anordnungen (2) mit einem Abschnitt des Rahmenmittels (3, 6, 7) verbindet.

2. Resonator nach Anspruch 1, dadurch gekennzeichnet, daß wenigstens eine der Anordnungen (2) wenigstens drei Schwingungsarme (2a) umfaßt, welche parallel zueinander angeordnet sind.

3. Resonator nach Anspruch 1 oder 2, dadurch gekennzeichnet, daß das Rahmenmittel (3, 6, 7) einen Montageabschnitt (7) umfaßt, welcher integral mit jeweiligen Enden eines Paars zueinander im Abstand angeordneter Rahmenabschnitte (6) verbunden ist, deren entgegengesetzte Enden direkt oder indirekt mit jeweiligen Brückenabschnitten (4) verbunden sind.

4. Resonator nach Anspruch 1 oder 2, dadurch gekennzeichnet, daß wenigstens eine der Anordnungen (2) sich von dem Rahmenmittel (3, 6, 7) nach außen erstreckt.

5. Resonator nach einem der vorhergehenden Ansprüche, dadurch gekennzeichnet, daß wenigstens drei der Anordnungen (2) vorhanden sind.

6. Resonator nach Anspruch 5, dadurch gekennzeichnet, daß eine zentral angeordnete der Anordnungen (2) mehr Schwingungsarme (2a) aufweist als die anderen.

7. Resonator an Anspruch 5 oder 6, dadurch gekennzeichnet, daß die zentral angeordnete Anordnung (2) sich über die anderen Anordnungen (2) hinaus nach außen erstreckt.

8. Resonator nach einem der Ansprüche 1, 2, 3, 5, 6 oder 7, dadurch gekennzeichnet, daß die Anordnung oder alle der Anordnungen (2) vollständig durch Abschnitte des Rahmenmittels (3, 6, 7) umgeben ist/sind.

9. Resonator nach einem der Ansprüche 5 bis 7, dadurch gekennzeichnet, daß nur die zentral angeordnete Anordnung (2) mit Anregungselektroden versehen ist, wobei die äußeren Anordnungen das Einschließen der Schwingungsenergie innerhalb der zentral angeordneten Anordnung unterstützen.

10. Längs-Quarzkristallresonator, umfassend: ein Paar von Schwingungsarmen (2a) , welche parallel zueinander angeordnet sind, Verbindungsabschnitte (8) zum Verbinden des Paars von Schwingungsarmen (2a) an ihren Enden, Brückenabschnitte (4), welche sich von Zwischenteilen der jeweiligen Schwingungsarme (2a) weg erstrecken, und ein Paar von Rahmenabschnitten (6) welche mit den jeweiligen Brückenabschnitten (4) verbunden sind und an ihren Enden integral getragen sind.

11. Längs-Quarzkristallresonator, umfassend: wenigstens drei Schwingungsarme (2a), welche parallel zueinander angeordnet sind, Verbindungsabschnitte (8) zum Verbinden der Schwingungsarme (2a) an ihren Enden, ein Paar von Brückenabschnitten (4), welche sich von Zwischenteilen eines äußersten Paars der Schwingungsarme weg erstrecken, und ein Paar von Rahmenabschnitten (6), welche mit den jeweiligen Brückenabschnitten (4) verbunden sind und an ihren Enden integral getragen sind.

## Revendications

1. Résonateur à quartz de forme longitudinale comportant des moyens (2) oscillants reliés par des moyens (4) de pontage à des moyens (3,6,7) formant cadre, caractérisé en ce que le résonateur comprend au moins un assemblage (2) de bras (2a) oscillants disposés parallèlement les uns aux autres; des parties (8) de connection qui relient les bras (2a) oscillants du dit au moins un assemblage (2) les uns aux autres à leurs extrémités opposées; et des parties (4) de pontage qui relient entre elles la partie centrale de chaque assemblage (2) à une partie des moyens (3,6,7) formant cadre.

2. Résonateur suivant la revendication 1, caractérisé en ce que le dit au moins un assemblage (2) comprend au moins trois bras (2a) oscillants disposés parallèlement les uns aux autres.

3. Résonateur suivant la revendication 1 ou 2, caractérisé en ce que les moyens (3,6,7) formant cadre comprennent une partie (7) de montage reliée aux extrémités respectives d'une paire de parties (6) de cadre à distance l'une de l'autre, la partie (7) étant d'une pièce avec les parties (6), dont les extrémités opposées sont reliées directement ou indirectement à des parties (4) de pontage correspondantes.

4. Résonateur suivant la revendication 1 ou 2, caractérisé en ce que le dit au moins un assemblage (2) s'étend vers l'extérieur des moyens (3,6,7) formant cadre.

5. Résonateur suivant l'une quelconque des revendications précédentes, caractérisé en ce qu'il y a au moins trois assemblages (2).

6. Résonateur suivant la revendication 5, caractérisé en ce qu'un des assemblages (2), placé de manière centrale, est muni de plus de bras (2a) oscillants que les autres assemblages.

7. Résonateur suivant la revendication 5 ou 6, caractérisé en ce que l'assemblage (2), placé de manière centrale, s'étend vers l'extérieur des autres assemblages (2).

8. Résonateur suivant l'une des revendications 1,2,3,5,6 ou 7, caractérisé en ce que le dit au moins un assemblage (2) est entièrement entouré de parties des moyens (3,6,7) formant cadre.

9. Résonateur suivant l'une des revendications 5 à 7, caractérisé en ce que seul l'assemblage (2) placé de manière centrale est muni d'électrodes d'excitation, les assemblages extérieurs aidant au confinement de l'énergie vibratoire à l'intérieur de l'assemblage placé de manière centrale.

10. Résonateur à quartz de forme longitudinale comprenant: une paire de bras (2a) oscillants disposés parallèlement l'un à l'autre, des parties (8) de connection destinées à relier la paire de bras (2a) oscillants à leurs extrémités, des parties (4) de pontage s'étendant des parties intermédiaires des bras (8) oscillants respectifs; et une paire de parties (6) de cadre reliées aux parties (4) de pontage respectives et supportées à leurs extrémités en ne faisant qu'une pièce avec ces parties (4) respectives.

11. Résonateur à quartz de forme longitudinale comprenant: au moins trois bras (2a) oscillants disposés parallèlement les uns aux autres; des parties (8) de connexion destinées à relier les bras (2a) oscillants à leurs extrémités; une paire de parties (4) de pontage s'étendant de parties intermédiaires d'une paire la plus à l'extérieur des bras oscillants; et une paire de parties (6) de cadre reliées aux parties (4) de pontage respectives et supportées à leurs extrémités en ne faisant qu'une pièce avec ces parties (4).
